# EUROPEAN PATENT APPLICATION

(11) **EP 1 621 525 A2**
(43) Date of publication of application: **01.02.2006**
(21) Application number: 05009023.2
(22) Date of filing: 25.04.2005
(51) Int. Cl.: C03C 17/00

(54) **Thick-film conductor paste**

(30) Priority: 30.06.2004 US 881920
(71) Applicant: E.I. DU PONT DE NEMOURS AND COMPANY, Wilmington, DE 19898 (US)
(72) Inventor: Belton, Cllifford Gerald, Bristol BS37 6JJ (GB); Garreau-Lles, Angélique Geneviève, Dursley GL11 4PB (GB)
(74) Representative: Towler, Philip Dean

(57) **Abstract**

A thick-film composition comprising: (a) conductive metal; (b) one or more inorganic binders; (c) antimony, antimony oxide, antimony-containing compound capable of forming an antimony oxide upon firing, or mixtures thereof; dispersed in (d) organic medium.

The windshield defogger element and a method of forming a windshield defogger element comprising: (a) providing the thick film composition as above; (b) providing a glass substrate; (c) printing the composition of (a) onto said glass substrate; and (d) firing said composition and substrate. A vehicle having as the conductive element in the windshield defroster system a windshield defogger element comprising an antimony oxide containing layer as a protective layer. A windshield defogger element comprising an antimony oxide containing layer as a protective layer.

## Description

### FIELD OF THE INVENTION

The present invention in general relates to a thick film conductor paste, and in particular to a thick film conductor composition with superior resistance to tarnishing. In one embodiment, the conductor composition may be used in a windshield defogger element used in the windshield defroster system of an automobile.

### BACKGROUND OF THE INVENTION

An important application of patterned electrically-conductive layers is in the automobile manufacturing industry, and particularly in the manufacture of windows which can be defrosted and/or demisted (defogged) by an electrically-conductive grid (windshield defogger element) permanently attached to the window and capable of producing heat when powered by a voltage source. In order for the window to defrost quickly, the circuit must be capable of supplying large amounts of power from a low voltage power source, typically 12 volts. For such power sources the resistivity requirement of the conductive pattern is generally in the range of from about 2 to about 6 µ┤ cm (6 m┤/square at 10 µm after firing). This requirement is readily met by conductors containing noble metals, particularly silver which is the most commonly-used material for this application.

The substances used in the production of grids for defogging windows include primarily, thick-film silver conductors which are manufactured from a paste composed of fine particles of silver powder and glass frit dispersed in an organic medium. In a typical application, a paste containing 70 wt % of silver powder, 5 wt % of glass frit and 25 wt % of organic medium is screen-printed through a 180 standard mesh screen onto a flat, un-formed rear window glass. The printed composition may optionally be dried at about 150°C, following which the substrate and silver paste composition are fired in air at 650°C for 2 to 5 minutes. After firing, the softened window glass is shaped by compression in a mold, then quenched by rapid cooling. The organic medium is removed by vaporization and pyrolysis in the firing cycle. The fired silver paste composition is referred to as a windshield defogger element or "hot wire". This element is a continuous electrically conductive path which is formed by sintering the glass and silver, and having the glass act as a binder for the silver particles. The defogger element is formed together with the window glass, thus creating a windshield defroster system.

The prior art relating to such thick-film conductor pastes for automotive glass includes the thick-film paste composition for use in conductive patterns on automotive window glass disclosed in JP 05009623 A, which discloses a composition including a mixture of fine particles containing (a) metallic silver, (b) glass frit having a softening point of 350 to 620°C, and (c) 0.01 to 10 wt %, based on the base paste, of the oxides of transition metals selected from among vanadium, manganese, iron, cobalt and mixtures thereof; wherein components (a), (b) and (c) are dispersed in (d) an organic medium, and the transition metals have a valence of 2⁺ or higher.

Other art of of interest includes U.S. Patent No. 5,601,638 to Fukada et al. that teaches a thick film paste that may be used in forming a conductor, resistor, insulator, or protector or the like in a ceramic wiring substrate by a screen printing process. However, the Fukada et al. thick film paste requires the use of a resin and a solvent containing 2-tetradecanol or a mixture of 2-tetradecanol with another solvent.

U.S. Patent No. 5,296,413 to Carroll et. al teaches a thick film composition for applying conductive patterns comprising finely divided metallic silver particles, glass frit, selected transitional metal oxides, and organic medium.

Additionally, U.S. 4,775,511 to Kono et. al discloses a method of sulfide tarnish inhibiting of silver-copper, silver-gold and silver-copper gold alloys. This method involves the addition of elements selected from the group consisting of Cr, Ta, Al, Ti and Th (with specific properties and in specific amounts) to the silver base alloys to inhibit sulfide tarnishing.

Typically, the defogger element or "hot wire" for defogging/defrosting is formed on the rear window glass (rear windshield) and plated to provide the desired weather resistance and resistivity. The defogger element is composed primarily of sintered silver and, in the absence of problems relating to resistivity and weatherability, is used without plating. When the fired silver paste, or "hot wire" is not plated, it is particularly susceptible to tarnishing.

This tarnishing is caused by a reaction between the silver and atmospheric sulfur to form silver sulfide. The rate of tarnishing is accelerated at higher temperature and humidity levels. As a result of the tarnishing, the hot wire is altered to a darker black/red/brown color. These dark colors formed from the reaction lead to an unaesthetically pleasing defogger window.

Accordingly, the present inventors desired to provide a composition which has demonstrated resistance to tarnishing in defogger elements and windshield defroster systems, and can satisfy the performance requirements for hot wires. "Performance requirements," as used herein, refers to such characteristics as resistivity, resistance, adhesion, coloration and printability.

### SUMMARY OF THE INVENTION

A thick-film composition comprising: (a) conductive metal; (b) one or more inorganic binders; (c) antimony, antimony oxide, antimony-containing compound capable of forming an antimony oxide upon firing, or mixtures thereof; dispersed in (d) organic medium.

The windshield defogger element and a method of forming a windshield defogger element comprising: (a) providing the thick film composition as above; (b) providing a glass substrate; (c) printing the composition of (a) onto said glass substrate; and (d) firing said composition and substrate. A vehicle having as the conductive element in the windshield defroster system a windshield defogger element comprising an antimony oxide containing layer as a protective layer. A windshield defogger element comprising an antimony oxide containing layer as a protective layer.

### DETAILED DESCRIPTION OF THE INVENTION

The use of thick-film conductors as components in hybrid microelectronic circuits is well known in the electronics field. Compositions for the manufacture of such components usually take the form of a paste-like solid-liquid dispersion, where the solid phase comprises finely divided particles of a noble metal or a noble metal alloy or mixtures thereof and an inorganic binder. The liquid vehicle for the dispersion is typically an organic liquid medium, but may also be an aqueous-based liquid medium. Additional materials may be added in small quantities (generally less than about 3% by weight of the composition) to modify the properties of the composition and these include staining agents, rheology modifiers, adhesion enhancers and sintering modifiers.

The consistency and rheology of the composition is adjusted to the particular method of application which may comprise screen printing, brushing, dipping, extrusion, spraying and the like. Typically, screen printing is used to apply the composition. The pastes are usually applied to an inert substrate, such as an alumina, glass, ceramic, enamel, enamel-coated glass or metal substrate, to form a patterned layer. The thick-film conductor layer is normally dried and then fired, usually at temperatures between about 600 and 900°C, to volatilize or burn off the liquid vehicle and sinter or melt the inorganic binder and the metal components. Direct wet-firing, i.e. wherein the thick film layer is not dried before firing, has also been used to generate the patterned layer. Upon firing the windshield defogger element is formed from the patterned layer.

Once formed, this defogger element is exposed to sulfur sources present in the atmosphere and in various other sources which lead to the formation of silver sulfide. This layer of silver sulfide may form on the surface of the patterned layer, which was initially light in color leading to a darker, unaesthetically pleasing windshield defogger element. The present inventor discovered that the addition of antimony, antimony oxides, antimony-containing compounds that can form a layer containing an antimony oxide or oxides upon firing, or mixtures thereof to the thick film conductor composition provides superior tarnish resistant qualities to the defogger element, while suprisingly still maintaining the performance requirements of the windshield defroster system.

This antimony/ antimony-containing compound present in the composition, upon firing, oxidizes to form a layer containing an antimony oxide. This antimony oxide containing layer is a protective layer at the surface of the defogger element which provides superior tarnish resistant qualities.

The antimony oxide containing layer may be a mixed antimony oxide layer due to incomplete oxidation. The oxidation of the antimony/antimony-containing compound may be incomplete thus resulting in a layer containing multiple antimony oxides, such as Sb₂O₅, Sb₂O₄, and Sb₂O₃.

For example, in one embodiment, the antimony/antimony containing compound in the thick film composition is antimony trioxide. The oxidation of this antimony trioxide in the composition results in an antimony oxide containing layer, at least some portion of which is antimony pentaoxide (Sb₂O₅).

As such, the present invention provides a thick-film conductor paste composition, which may be used in windshield defroster systems and which comprises (a) conductive metal, (b) inorganic binder, (c) antimony, antimony oxides, antimony-containing compound capable of forming an antimony oxide upon firing, or mixtures thereof; wherein components (a), (b), and (c) are dispersed in (d) an organic medium. The components of the present composition are discussed in detail below.

### A. Conductive Metal

The metals used in the preparation of thick-film conductor compositions are typically selected from silver, gold, platinium and palladium. The metal can be used either in isolation or as a mixture which forms an alloy upon firing. Common metal mixtures include platinum/gold, palladium/silver, platinum/silver, platinum/palladium/gold and platinum/palladium/silver. The most common systems used in the manufacture of heating elements are silver and silver/palladium.

As stated above, the metals used in the preparation of thick-film conductor compositions are typically selected from silver, gold, platinium and palladium. Any of these metals or mixtures thereof may be utilized in the present invention. Furthermore, by controlling the ratio of conductive components to non-conductive components of the thick film composition, the conductivity of the composition may be manipulated.

Silver flakes or powder can be used in the practice of the present invention. Although the silver particle size itself is not subject to narrow limitations from the standpoint of the technical effects, a size of 0.1 to 15 microns, and especially 0.5 to 5.0 microns, is preferred.

When the particles are larger than 15 microns, the coarseness of the particles slows the sintering process and makes it difficult to achieve the desired resistivity.

On the other hand, when the particles are smaller than 0.1 micron, sintering proceeds too rapidly, resulting in undesirable effects such as the rising of glass to the surface and/or cracks in the enamel/glass at the edges of the silver tracks.

Accordingly, the inventive composition contains at least 40 to 90 wt %, based on the paste, of silver particles having an average particle size of 1.0 to 5.0 microns. Preferably, the content of the conductive metal is in the range of 65 to 85 wt %, based on the paste. The content of metal powder is determined to achieve an appropriate thickness of the composition upon firing. If a composition of less than 50 wt % conductive metal is used, the film becomes thinner resulting in poor film strength and a decrease in resistivity.

The silver generally is of high purity (99+%). However, depending on the electrical requirements of the pattern, it is also possible to use material of lower purity.

### B. Inorganic Binders

The inorganic binder is typically a glass or glass-forming material, such as a lead silicate, and functions as a binder both within the composition and between the composition and substrate onto which the composition is coated. Due to environmental considerations, the use of lead-containing binders is becoming less common and lead-free binders such as zinc or bismuth borosilicates are now often employed.

Suitable inorganic binders for use in the present invention are those materials which upon sintering serve to bind the metal to a substrate such as a glass (including toughened and laminated glass), enamel, enamel-coated glass, ceramic, alumina or metal substrate. The inorganic binder, also known as a frit, comprises finely-divided particles and is a key component in the compositions described herein. The softening point and viscosity of the frit during firing, as well as its wetting characteristics for the metal powder/flake and the substrate, are important factors. The particle size of the frit is not narrowly critical and frits useful in the present invention will typically have an average particle size from about 0.5 to about 4.5 µm, preferably from about 1 to about 3 µm.

It is preferred that the inorganic binder is a frit having a softening point of between about 350 and 620°C in order that the compositions can be fired at the desired temperatures (typically 300 to 700°C, particularly 580 to 680°C) to effect proper sintering, wetting and adhesion to the substrate, particularly a glass substrate. It is known that mixtures of high and low melting frits can be used to control the sintering characteristics of the conductive particles. In particular, it is believed that the high temperature frit dissolves in the lower melting frit and together they slow the sintering rate of the conductive particles as compared to pastes containing only low melting frit. This control of the sintering characteristics is especially advantageous when the composition is printed and fired over decorative enamels. (Decorative enamels are normally pastes comprised of one or more pigment oxides and opacifiers and glass frit dispersed in an organic medium.) A high melting frit is considered to be one having a softening point above 500°C and a low melting frit is considered to be one having a softening point below 500°C. The difference in the melting temperatures of the high and low melting frits should be at least 100°C and preferably at least 150°C. Mixtures of three or more frits having different melting temperatures can also be used. When mixtures of high and low melting frits are used in the invention, they are normally used in ratios by weight from 4:1 to 1:4. As used herein, the term "softening point" refers to softening temperatures obtained by the fibre elongation method of ASTM C338-57.

Suitable binders include lead borates, lead silicates, lead borosilicates, cadmium borate, lead cadmium borosilicates, zinc borosilicates, sodium cadmium borosilicates, bismuth silicates, bismuth borosilicates, bismuth lead silicates and bismuth lead borosilicates. Typically, any glass having a high content of bismuth oxide, preferably at least 50% and more preferably at least 70% by weight bismuth oxide, is preferred. Lead oxide as a separate phase may also be added, if necessary. However, due to environmental considerations, lead-free binders are preferred. Some of the glass frit compositions of the present invention may comprise, based on weight percent of total glass frit composition, 4-38 % SiO₂, 0-27 % B₂O₃, 0-95 % Bi₂O₃, 0-44 % PbO, 0-4 % ZrO₂, 0-17 % GeO₂, 0-9 % Na₂O, 0-6 %Al₂O₃, and 0-33 % MO where M is selected from Ba, Co, Ca, Zn, Cu, or mixtures thereof.

Examples of glass compositions (compositions A to I) are given in Table 1 below; the oxide components are given in weight percent.

**Table 1 - Glass Compositions**

| | A | B | C | D | E | F | G | H | I |
|---|---|---|---|---|---|---|---|---|---|
| Bi₂O₃ | 75.1 | 82.7 | | | 78.1 | 94.8 | 73.3 | 73.7 | 69.82 |
| PbO | 10.9 | 1.83 | 43.6 | 0.7 | | | | | |
| B₂O₃ | 1.2 | 1.34 | 4.8 | 26.7 | | | | | 8.38 |
| SiO₂ | 9.3 | 10.3 | 37.5 | 21.7 | 8.6 | 5.2 | 4.7 | 4.8 | 7.11 |
| CaO | 2.4 | 2.68 | 9.7 | 4.0 | | | | | 0.53 |
| BaO | | | | 0.9 | | | | | |
| ZnO | | | | 27.6 | 3.9 | | | 5.0 | 12.03 |
| CuO | | | | | 7.6 | | 5.5 | | |
| CoO | | | | | 1.8 | | | | |
| Al₂O₃ | 1.1 | 1.22 | 4.3 | 5.7 | | | | | 2.13 |
| Na₂O | | | | 8.7 | | | | | |
| ZrO₂ | | | | 4.0 | | | | | |
| GeO₂ | | | | | | | 16.5 | 16.6 | |

The glass binders are prepared by conventional glass-making techniques, by mixing the desired components (or precursors thereof, e.g., H₃BO₃ for B₂O₃) in the desired proportions and heating the mixture to form a melt. As is well known in the art, heating is conducted to a peak temperature and for a time such that the melt becomes entirely liquid, yet gaseous evolution has ceased. The peak temperature is generally in the range 1100°C-1500°C, usually 1200°C-1400°C. The melt is then quenched by cooling the melt, typically by pouring onto a cold belt or into cold running water. Particle size reduction can then be accomplished by milling as desired.

Other transition metal oxides may also be employed as part of the inorganic binder, as is well known to those skilled in the art. Oxides or oxide precursors of zinc, cobalt, vanadium, copper, nickel, manganese and iron are commonly used, particularly with substrates other than glass substrates, such as alumina substrates. These additives are known to improve soldered adhesion.

The inorganic binder can also contain up to approximately 4 parts by weight basis paste of a pyrochlore-related oxide having the general formula:

(MₓM'₂₋ₓ)M"₂O_{7-Z}

wherein
M is selected from at least one of Pb, Bi, Cd, Cu, Ir, Ag, Y and rare earth metals having atomic numbers of 57-71 and mixtures thereof,
M' is selected from Pb, Bi and mixtures thereof,
M" is selected from Ru, Ir, Rh and mixtures thereof,
X=0-0.5, and
Z=0-1.

Pyrochlore materials have been described in detail in U.S. Patent No. 3,583,931, the disclosure of which is incorporated herein by reference. The pyrochlore materials act as adhesion promoters for the compositions of this invention. Copper bismuth ruthenate (Cu_{0.5}Bi_{1.5}Ru₂O_{6.75}) is preferred.

Traditionally, conductive compositions have been based on lead frits. The elimination of lead from glass compositions to meet current toxicity and environmental regulations may limit the types of binder that can be used to achieve the desired softening and flow characteristics, while simultaneously meeting wettability, thermal expansion, cosmetic and performance requirements. U.S. Patent No. 5,378,406, the disclosure of which is incorporated herein by reference, describes a series of low-toxicity lead-free glasses based upon the constituents Bi₂O₃, Al₂O₃, SiO₂, CaO, ZnO and B₂O₃, all of which may be used in the compositions described herein. In a preferred embodiment, the frit is composition I in Table 1 herein.

The total glass frit present in the composition is in the range of 1 weight percent to 10 weight percent, based on total composition.

In a further embodiment of the present invention the composition may contain two types of inorganic glass binders: amorphous glass and crystallized glass.

### 1. Amorphous Glass Binder

The chemical composition of the amorphous glass binder has little import on the function of the invention. For example, lead borosilicate is widely used in pastes for automotive glass, and can be used in working the present invention as well.

Lead silicate and lead borosilicate glass are preferable from the standpoint of both the range in their softening points and their glass bondability.

One specific example of the composition of amorphous glass binder that may be used in the present invention comprises the following oxide constituents: SiO₂ 36.9%, ZrO₂ 3.0%, B₂O₃ 3.0%, Na₂O 1.3%, Li₂O 3.0%, Bi₂O₃ 46.8%, TiO₂ 3.0%, K₂O 3.0% in weight % based on the weight of the total composition.

### 2. Crystallized Glass Binder

A crystalline material is defined as one that has an orderly periodic array of atoms, and gives rise to distinct diffraction peaks when subjected to X-rays. This crystalline structure contrasts with glasses in general that have a disordered arrangement, with no long term ordering of the atoms and diffuse X-ray diffraction patterns. It is important to the function of the crystallized glass binder that the binder manifest sufficient crystallinity at the peak temperature range during firing. Because the composition is typically fired at approximately 580 to 620°C, the crystallization point is preferably within a range of 300 to 610°C, and most preferably from 500 to 610°C.

At a crystallization point above 610°C, a sufficient crystalline phase is not obtained upon the completion of firing and so does not improve the wear resistance of the conductor.

On the other hand, at less than 300°C, the flow properties due to crystallization decline, preventing a uniform dispersed state from being achieved and also lowering the sinter-promoting effects resulting from the action of the liquid phase.

One embodiment of the crystalline glass binder used in the present invention is commercially available from Asahi Glass (Product Number ASF1280). The main composition of this Asahi Glass embodiment is 55 wt.% PbO and 24 wt. % Al2O3.

### C. Antimony or Antimony-containing Compounds

The antimony or antimony-containing compounds are essential to the present invention. The present invention incorporates the addition of antimony, antimony oxide, an antimony-containing compound that can form an antimony oxide upon firing, or mixtures thereof into the thick film conductor composition.

The antimony/antimony-containing compounds may be present in amounts of up to 10 weight percent, based on total composition. Preferrably, the antimony/antimony-containing compounds are present in amounts of less than 2 weight percent, based on total composition.

In one embodiment, the antimony-containing compound present in the thick film composition is antimony trioxide and is supplied with a solids content of the raw material of 94-100 weight %, based on total raw antimony material and a surface area to weight ratio of 1.4-3.4 m²/g.

### D. Organic Medium

The role of the organic medium is to disperse the particulate components and to facilitate the transfer of the composition onto the substrate. The metal composition of the present invention is generally formed into a paste that can be printed in the desired circuit pattern.

Any suitable inert liquid may be used as the organic medium, although a nonaqueous inert liquid is preferred. Use can be made of any one of various organic liquids which may or may not contain a thickener, a stabilizer and/or other common additives. Examples of organic liquids that can be used include alcohols, esters of such alcohols (e.g., acetic acid and propionates), terpenes (e.g., pine oil, terpineol), resin (e.g., polymethacrylate) solutions, solutions of ethyl cellulose in a solvent (e.g., pine oil), and the monobutyl ether of ethylene glycol monoacetate. The preferred organic medium is composed of ethyl cellulose in terpineol (in a 1:9 ratio), and is based on a combination with a thickener blended with butyl carbitol acetate. The paste is conveniently produced using a three-roll mill. The preferred viscosity of such compositions is about 20 to 100 Pa·s, as measured with a Brookfield HBT viscometer using a #5 spindle at 10 rpm and 25°C. The amount of thickener depends on the viscosity of the ultimately desired composition. That is, it depends on the conditions required for printing. The organic medium generally accounts for 5 to 50 wt % of the paste.

### General Production of Windshield Defogger Element and Overall Windshield Defroster System

The following procedure may be used to manufacture a windshield defogger element or defogging circuit: A solvent-base or UV-curable type of decorative enamel paste may be optionally printed onto a flat glass substrate typically, by using conventional screen printing technology. The screen is typically a 156 or 195 mesh polyester screen, but other types and sizes may be similarly used. The printed enamel pattern is then dried or cured. Typical conditions are at 150°C for 15 minutes or UV cured at 1.2 J/cm², depending on the type of enamel. Next, the thick film conductor paste of the present invention may be screen-printed onto the air side or tin side of a flat glass substrate, or onto the unfired enamel, using a conventional screen, typically a 195 mesh polyester screen. Other types or mesh sizes, such as 156 or 230 mesh, may also similarly be used. The thick film conductor paste may then be dried if necessary. Typical drying is at about 150°C for at least 2 minutes. Next, the thick film conductor paste may then be fired, or both the thick film conductor paste and enamel may be fired together, in a belt oven in which the peak glass surface temperature reaches approximately 580 to 680°C.

After firing, the softened window glass is shaped by compression in a mold or by sagging and then quenched by rapid colling. The organic medium in the paste is removed by vaporization and pyrolysis in the firing cycle. Upon firing the paste forms a continuous electrically conductive path (the windshield defroster element) which is formed by sintering the glass and silver, and having the glass act as a binder for the silver particles. The whole ensemble, including the window glass forms the complete windshield defroster system.

### EXAMPLES

### Test Procedures

### Tarnish Color Test

The fired parts were placed in a 10 liter round reaction vessel with a lid. Thelid was not air tight. The fired parts were placed all around the sides of the reaction vessel to give a central geometry to the test in order to have equal exposure for each part. Inside the reaction vessel, 5 grams of flower of sulfur were placed in a dish floating on another dish containing 100 ml of water. The vessel was placed in an oven at 70°C for 48 hours. After 48 hours, the parts were examined for a change in color by comparison with non-tarnished parts. The parts which exhibited a visable change in color were deemed to be tarnished.

### Resistance and Resistivity

The resistance of the fired conductive pattern on a glass substrate (dimensions 10.2 cm x 5.1 cm x 3 mm) was measured using a GenRad Model 1657 RLC bridge calibrated for use between 1 and 900┤ or equivalent. The thickness of the conductive layer is measured using a thickness measuring device such as a surf-analyser (e.g. TALYSURF (a contact measuring device which analyses the substrate surface in 2 dimensions using a spring loaded stylus; any change in height deflects the stylus, which is registered on a recorder, such as a chart recorder; the difference between the base line and average height gives the print thickness)). Resistance of the pattern is determined by placing the probe tips at the point where the conductive track meets the solder pads. The bulk resistivity (thickness-normalised) of the layer is determined by dividing the measured resistance for the pattern by the number of squares therein where the number of squares is the length of the conductive track divided by the width of the track. The resistivity value is obtained as m┤/Y at a normalised thickness, herein 10 µm, and presented herein in the units of µ┤ cm.

### Adhesion

Copper clips (obtained from Quality Product Gen. Eng. (Wickwar), UK) are soldered to the fired conductive pattern on a glass substrate (dimensions 10.2 cm x 5.1 cm x 3 mm) using a 70/27/3 Pb/Sn/Ag solder alloy at a soldering iron temperature of 350 to 380°C. A small quantity of a mildly active rosin flux, such as ALPHA 615-25® (Alpha Metals Limited, Croydon, U.K.) may be used to enhance solder wetting and to keep the solder and clip in place during assembly of parts, in which case the flux is applied to the solder using a shallow tray containing a thin film of fresh flux. Adhesion was measured on a Chattillon® pull tester Model USTM at a pull speed of 0.75 ± 0.1 inches per minute (1.91 ± 0.25 cm per minute) and the pull strength recorded at adhesion failure. The average value of adhesion failure over 8 samples was determined. The adhesion should preferably be greater than 10 kg, more preferably greater than 15 kg and more preferably greater than 20 kg. The principal failure modes of adhesion are as follows:
(a) clip separates from the conductive pattern (i.e. poor solder adhesion).
(b) the conductive pattern separates from the substrate (i.e. poor substrate adhesion).
(c) glass pullout/fracture (i.e. the bonding strengths between the clip and the conductive layer and between the conductive layer and the substrate is greater than the strength of the substrate.
(d) failure within the solder.

The five types of silver paste shown in Table 2 were prepared and used to compare a composition according to this invention with silver pastes of prior-art compositions that are used in windshield defroster systems. Working Example 5 illustrates the present invention, and the other examples are comparative examples for comparison with the present invention.

### Advantages of the Invention

While the composition of the present invention may be utilized on a variety of substrates, the composition has particular utility on glass substrates in the automotive industry. The inventive thick film composition for vehicle glass having the above-described composition, when used to form an electrically conductive grid on vehicle windows (windshield) for use in defroster system applications, provides, a windshield defogger element with superior tarnish resistance properties while still maintaining adequate system performance requirements.

**Table 2**

| | | Prior-art Example 1 | Prior-art Example 2 | Prior-art Example 3 | Prior-art Example 4 | Working Example 5 |
|---|---|---|---|---|---|---|
| | | DuPont Commercial Product# 7881 | DuPont Commercial Product# 7883 | JM Commercial Product# JM 2303-60 | JM Commercial Product# JM 2303-80 | Present Invention |
| Silver | wt % | 80 | 65 | 61 (total solids) | 82 (total solids) | 80 |
| Glass Binder | wt % | 4 | 3 | | | 4 |
| Organic Medium | wt % | 16 | | | | 16 |
| Sb₂O₃ | wt % | 0 | 0 | 0 | 0 | 0.2 |
| Tarnish Color Test | | Tarnished | Tarnished | Tarnished | Tarnished | Virtually Untarnished |
| Thickness | µm | | | 3.80 | 11.00 | |
| Resistance | Ω | | | 8.22 | 2.76 | |
| Resistivity | mΩ/□at 10 µm | 2.72+/-0.2 (average on population of 15 lots) | 4.31+/-0.7 (average on population of 8 lots) | 3.12 | 3.03 | ~5.0 |
| Adhesion | Kg | 27.8+/-2 (average on population of 15 lots) | 24.6+/-2 (average on population of 8 lots) | 20.36 | 30.08 | 23.9 non burnished 31.5 burnished |

## Claims

1. A thick-film composition comprising:
(a) conductive metal;
(b) one or more inorganic binders;
(c) antimony, antimony oxide, antimony-containing compound capable of forming an antimony oxide upon firing, or mixtures thereof; dispersed in
(d) organic medium.

2. The composition of Claim 1 wherein said conductive metal is selected from silver, gold, platinum, palladium, or mixtures thereof.

3. The composition of Claim 1 wherein said inorganic binder comprises a glass frit.

4. The composition of Claim 3 wherein said glass frit comprises, based on weight percent of total glass frit composition, 4-38 % SiO₂, 0-27 % B₂O₃, 0-95 % Bi₂O₃, 0-44 % PbO, 0-4 % ZrO₂, 0-17 % GeO₂, 0-9 % Na₂O, 0-6 %Al₂O₃, and 0-33 % MO where M is selected from Ba, Co, Ca, Zn, Cu, and mixtures thereof.

5. The composition of Claim 1 wherein said inorganic binder includes fine particles of a transition metal oxide selected from among oxides of zinc, copper, vanadium, manganese, iron, cobalt, and mixtures thereof.

6. The thick film composition of Claim 1 wherein said conductive metal is present in the amount of 40 to 90 weight %, based on the weight of the total composition.

7. The composition of Claim 1 wherein said antimony, antimony oxide, antimony-containing compound capable of forming an antimony oxide upon firing, or mixtures thereof are present in the amount of up to 10 weight %, based on the weight of the total composition.

8. The composition of Claim 3 wherein said glass frit is present in the range of 1 to 10 weight percent, based on the weight of the total composition.

9. The composition of Claim 1 wherein said inorganic binder comprises an amorphous glass binder and a crystallized glass binder.

10. A method of forming a windshield defogger element comprising:
(a) providing the thick film composition of Claim 1;
(b) providing a glass substrate;
(c) printing the composition of (a) onto said glass substrate; and
(d) firing said composition and substrate.

11. A windshield defogger element comprising an antimony oxide containing layer as a protective layer.

12. A vehicle having as the conductive element in the windshield defroster system the windshield defogger element of Claim 11.
